# EUROPÄISCHE PATENTSCHRIFT

(11) **EP 2 992 571 B1**
(45) Veröffentlichungstag und Bekanntmachung des Hinweises auf die Patenterteilung: **28.06.2017**
(21) Anmeldenummer: 14724684.7
(22) Anmeldetag: 08.05.2014
(51) Int. Cl.: H01R 9/26, H01R 9/24, H05K 7/14, H01R 4/48, H01R 4/34

(54) **BUSANSCHLUSSVORRICHTUNG**
BUS CONNECTION DEVICE
DISPOSITIF DE CONNEXION D'UN BUS

(30) Priorität: 12.07.2013 DE 102013213724
(43) Veröffentlichungstag der Anmeldung: 09.03.2016
(73) Patentinhaber: Siemens Aktiengesellschaft, 80333 München (DE)
(72) Erfinder: JEDYNSKI, Wieslaw, 90522 Oberasbach (DE); PRÖLSS, Manfred, 92263 Ebermannsdorf (DE)
(86) Internationale Anmeldenummer: PCT/EP2014/059411
(87) Internationale Veröffentlichungsnummer: WO 2015/003831

(56) Entgegenhaltungen:
- EP-A1- 1 403 969
- DE-A1- 19 506 862
- DE-A1- 19 648 351

## Beschreibung

Die Erfindung betrifft eine Vorrichtung zum Anbinden eines Feldbusses an ein Feldgerät, welches insbesondere ein Motormanagement System ist.

Das Feldgerät dient insbesondere dem Steuern und Schützen eines Elektromotors im Niederspannungsbereich. Derartige Feldgeräte werden insbesondere innerhalb der industriellen Automatisierungstechnik eingesetzt. Zum Steuern und Schützen des Elektromotors ist das Feldgerät vorzugsweise mit einem Schütz, welches in den Hauptstromkreis des Elektromotors (Motorabzweig) integriert ist, verbunden und kann dieses steuern. Ferner kann das Feldgerät Strom- und/oder Spannungswerte des Motorabzweiges erfassen und auswerten. Anhand der erfassten und ausgewerteten Strom- und/oder Spannungswerte kann beispielsweise ein Überlastschutz für den Elektromotor des Motorabzweiges erfolgen. Detektiert das Feldgerät anhand der erfassten und ausgewerteten Strom- und/oder Spannungswerte einen kritischen Zustand für den Elektromotor (z.B. eine Überlast), so kann es über das Schütz die Energieversorgung zum Elektromotor abschalten und hierüber einen sicheren Zustand für den Elektromotor herbeiführen. Ein derartiges Feldgerät ist beispielsweise das Gerät "SIMOCODE pro" der Firma Siemens.

Zur Integration derartiger Feldgeräte in ein Automatisierungssystem kann das Feldgerät über einen Feldbus (z.B. PROFIBUS, Modbus oder CAN) mit einer übergeordneten Steuerung kommunikativ verbunden werden. Eine derartige Steuerung ist beispielsweise eine speicherprogrammierbare Steuerung (kurz: SPS). Auf diese Weise kann eine optimierte Überwachung und Analyse des Automatisierungssystems erfolgen. Zur Integration des Feldgerätes in das Bussystem der übergeordneten Steuerung muss das Feldgerät mit dem Feldbus der übergeordneten Steuerung verbunden werden. Hierfür muss das Feldgerät einen Anschluss für den Feldbus aufweisen. Der Feldbus wird üblicherweise über einen Stecker mit dem Feldgerät verbunden. Dies kann im Fall von PROFIBUS beispielsweise mittels eines 9-poligen SUB-D Steckers der Feldbusleitung erfolgen. Das Feldgerät muss als Gegenstück eine PROFIBUS DP Schnittstelle (9-polige SUB-D Buchse) aufweisen. Der Feldbus wird hierbei über den Stecker, in welchem die Feldbusleitung kontaktiert und der Schirm aufgelegt wird, an der D-SUB-Buchse des Feldgerätes angeschlossen. Über den Kragen des Steckers erfolgt die Schirmanbindung. Die Feldbusleitung wird über den Stecker mechanisch am Feldgerät fixiert. Für den Fall der Linientopologie des Feldbussystems haben die Stecker zwei Leitungsanschlüsse für die beiden Feldbusleitungen.

Eine Aufgabe der vorliegenden Erfindung ist es, einen verbesserten Anschluss eines Feldbusses an ein Feldgerät bereitzustellen. Die Anbindung des Feldbusses soll insbesondere derart ausgebildet sein, dass auch während eines Tausches des Feldgerätes die Kommunikation über den Feldbus erfolgen kann.

Diese Aufgabe wird gelöst durch eine Vorrichtung gemäß Anspruch 1, d.h. durch eine Vorrichtung zum Anbinden eines Feldbusses an ein Feldgerät mit einem ersten Verbindungsmodul und einem separaten zweiten Verbindungsmodul, wobei das erste Verbindungsmodul ein erstes und zweites Verbindungsmittel umfasst, wobei das erste Verbindungsmittel dem mechanischen Verbinden des ersten Verbindungsmoduls mit dem Feldgerät dient, das zweite Verbindungsmittel der mechanischen Fixierung zweier Leitungen, welche vorzugsweise jeweils einen Leitungsschirm umfassen, mit dem ersten Verbindungsmodule und der elektrischen Kontaktierung des Leitungsschirms der beiden Leitungen mit einem Schirmanbindungsleiter dient, wobei das zweite Verbindungsmodul getrennt vom ersten Verbindungsmodul mit dem Feldgerät mechanisch und elektrisch verbunden werden kann, wobei das zweite Verbindungsmodul ein Anschlussmittel umfasst, über welches Kabel der beiden Leitungen mechanisch und elektrisch mit dem zweiten Verbindungsmodul verbunden werden können, wobei das zweite Verbindungsmodul derart ausgebildet ist, dass im mechanisch verbundenen Zustand des zweiten Verbindungsmoduls mit dem Feldgerät die Kabel elektrisch leitend mit dem Feldgerät verbunden sind.

Vorteilhafte Weiterbildungen der Erfindung sind in den abhängigen Ansprüchen 2 bis 13 angegeben.

Die beiden Leitungen sind insbesondere Leitungen eines Feldbusses. Der Feldbus ist vorzugsweise ein Profibus-DP Feldbus.

Die beiden Leitungen umfassen jeweils ein Kabel, vorzugsweise zwei, welche von einem Leitungsschirm umgeben sind. Das zweite Verbindungsmittel dient neben der mechanischen Fixierung der beiden Leitungen mit dem ersten Verbindungsmodul ferner als Schirmauflage. Über das zweite Verbindungsmittel kann insbesondere ein Schirmanbindungsleiter, welcher vorzugsweise als Kabel ausgebildet ist, mit den Leitungsschirmen der beiden Leitungen elektrisch leitend verbunden werden. Dieser Schirmanbindungsleiter kann vorzugsweise ferner mit dem zweiten Verbindungsmodul elektrisch leitend verbunden werden. Der Schirmanbindungsleiter dient der Anbindung des Schirms der Leitungen des Feldbusses an das Feldgerät.

Das zweite Verbindungsmodul ist vorzugsweise modular mechanisch lösbar am Feldgerät befestigt.

Die mechanische Verbindung des ersten Verbindungmoduls mittels des ersten Verbindungsmittels mit dem Feldgerät sowie die mechanische Verbindung des zweiten Verbindungmoduls mit dem Feldgerät erfolgt vorzugsweise mittels einer Schnapp-oder Rastverbindung. Diese mechanische Verbindung ist vorzugsweise eine lösbare Verbindung.

Durch das erste Verbindungsmodul kann ein mechanisches Fixieren der beiden Leitungen am Feldgerät sichergestellt werden.

Das zweite Verbindungsmittel ermöglicht das elektrische Kontaktieren des Schirms der beiden Leitungen.

Das zweite Verbindungsmodul ermöglicht das elektrische Kontaktieren der Kabel der beiden Leitungen mit dem Feldgerät.

Da ein Feldbus in Linien-Topologie aufgebaut sein kann, wird vorzugsweise mittels des zweiten Verbindungsmoduls die kommende und gehende Leitung elektrisch leitend miteinander verbunden. Hierfür ist vorzugsweise jeweils ein Kabel der kommenden Leitung mit einem Kabel der gehenden Leitung elektrisch leitend innerhalb des zweiten Verbindungsmoduls verbunden. Hierdurch ist ein Tausch des Feldgerätes ohne Unterbrechung der über den Feldbus erfolgenden Kommunikation möglich. Eine Steuerung des Feldbussystems kann somit trotz Tausch des Feldgerätes weiterhin mit anderen mit dem Feldbus verbundenen Feldgeräten über den Feldbus kommunizieren.

In einer vorteilhaften Ausführungsform der Erfindung umfasst die Vorrichtung das Feldgerät. Das zweite Verbindungsmodul ist mechanisch lösbar mit dem Feldgerät verbindbar.

Das zweite Verbindungsmodul ist vorzugsweise modular am Feldgerät befestigt. Die elektrische Kontaktierung des/der am Anschlussmittel angeschlossenen Kabel mit dem Feldgerät erfolgt vorzugsweise über mindestens eine im zweiten Verbindungsmodul geführte elektrisch leitende Leitung, welche zu einer zugehörigen Kontaktstelle des Feldgerätes geführt ist. Durch das mechanische Koppeln des zweiten Verbindungsmoduls mit dem Feldgerät erfolgt die elektrisch leitende Verbindung des Kabels über das zweite Verbindungsmodul mit der zugehörigen Kontaktstelle des Feldgerätes.

Das zweite Verbindungsmodul ist vorzugsweise eine abnehmbare Klemme des Feldgerätes.

In einer weiteren vorteilhaften Ausführungsform der Erfindung umfasst das Feldgerät zur mechanischen Verbindung mit dem zweiten Verbindungsmodul ein zweites Aufnahmemittel, wobei die mechanische Verbindung zwischen dem zweiten Aufnahmemittel und dem zweiten Verbindungsmodul eine formschlüssige Verbindung ist. Das zweite Aufnahmemittel und das zweite Verbindungsmodul sind derart ausgebildet, dass das zweite Verbindungsmodul mit dem zweiten Aufnahmemittel mittels einer formschlüssigen Verbindung miteinander verbunden werden kann.

Die formschlüssige Verbindung ist vorzugsweise eine Schnapp-oder Rastverbindung. Das zweite Verbindungsmodul kann über das zweite Aufnahmemittel auf das Feldgerät aufgeschnappt oder mit dem Feldgerät verrastet werden, so dass eine mechanisch stabile Verbindung zwischen dem Feldgerät und dem zweiten Verbindungsmodul vorliegt. Diese mechanische Verbindung kann insbesondere ohne Zuhilfenahme eines Werkzeuges seitens eines Installateurs erfolgen.

Die formschlüssige Verbindung des zweiten Verbindungsmoduls mit dem Feldgerät über das zweite Aufnahmemittel ist insbesondere eine mechanisch zerstörungsfreie lösbare Verbindung, so dass ein erneutes mechanisches Verbinden erfolgen kann.

Durch das mechanische Verbinden des zweiten Verbindungmoduls über das zweite Aufnahmemittel mit dem Feldgerät erfolgt ferner eine elektrische Verbindung des Anschlussmittels des zweiten Verbindungmoduls mit dem Feldgerät. Hierfür umfasst das Feldgerät mindestens eine Kontaktstelle.

In einer weiteren vorteilhaften Ausführungsform der Erfindung umfasst das Feldgerät zur mechanischen Verbindung mit dem ersten Verbindungsmodul ein erstes Aufnahmemittel, wobei die mechanische Verbindung zwischen dem ersten Aufnahmemittel und dem ersten Verbindungsmittel des ersten Verbindungsmoduls eine formschlüssige Verbindung ist. Das erste Aufnahmemittel und das erste Verbindungsmittel des ersten Verbindungsmoduls sind derart ausgebildet, dass das erste Verbindungmittel mit dem ersten Aufnahmemittel mittels einer formschlüssigen Verbindung miteinander verbunden werden kann.

Die formschlüssige Verbindung ist vorzugsweise eine Schnapp-oder Rastverbindung. Das erste Verbindungmodul kann mittels seines ersten Verbindungsmittels auf das erste Aufnahmemittel des Feldgerätes aufgeschnappt oder mit dem ersten Aufnahmemittel verrastet werden, so dass eine mechanisch stabile Verbindung zwischen dem Feldgerät und dem ersten Verbindungsmodul vorliegt. Diese mechanische Verbindung kann insbesondere ohne Zuhilfenahme eines Werkzeuges seitens eines Installateurs erfolgen. Die formschlüssige Verbindung des ersten Verbindungsmoduls mit dem Feldgerät über das erste Aufnahmemittel ist insbesondere eine mechanisch zerstörungsfreie Verbindung, so dass ein erneutes mechanisches Verbinden erfolgen kann.

In einer weiteren vorteilhaften Ausführungsform der Erfindung befindet sich das erste und zweite Aufnahmemittel auf der gleichen Seitenfläche des Feldgerätes. Das erste und zweite Verbindungsmodul kann folglich getrennt voneinander über die gleiche Seitenfläche des Feldgerätes mit dem Feldgerät verbunden werden. Dies erleichtert die Installation.

In einer weiteren vorteilhaften Ausführungsform der Erfindung umfasst das Anschlussmittel mindestens ein Cage Clamp Anschluss oder ein Schraubanschluss. Über den Cage Clamp Anschluss oder ein Schraubanschluss erfolgt die elektrische sowie mechanische Anbindung der Kabel der beiden Leitungen mit dem zweiten Verbindungsmodul.

Ein Cage Clamp Anschluss ist eine Federzugklemme, mittels welcher ein Kabel ohne externes Werkzeug mechanisch und elektrisch angeschlossen werden kann. Auf diese Weise kann ein Kabel mit dem Anschlussmittel mechanisch und elektrisch verbunden werden. Die Cage Clamp Anschlusstechnik ermöglicht für starre oder mit Aderendhülsen versehene Kabel eine schnelle, werkzeuglose Verdrahtung. Zum Lösen der mechanischen Verbindung des Kabels ist ein Schraubendreher notwendig. Der Vorteil der Cage Clamp Anschlusstechnik liegt in der Montage-und Demontagegeschwindigkeit und in der rüttelsicheren Verbindung. Ein Kontrollieren und Nachziehen wie bei Schraubanschlussklemmen entfällt.

Durch das mechanische Verbinden des zweiten Verbindungsmoduls mit dem Feldgerät erfolgt automatisch eine elektrische Verbindung des mindestens einen Cage Clamp Anschlusses oder Schraubanschlusses mit einer zugehörigen Kontaktstelle am Feldgerät.

In einer weiteren vorteilhaften Ausführungsform der Erfindung weist das Anschlussmittel einen ersten und zweiten Cage Clamp Anschluss oder einen ersten und zweiten Schraubanschluss auf. Die beiden Leitungen des Feldbussees umfassen vorzugsweise jeweils zwei Kabel. Zur Verbindung der beiden Leitungen wird ein erstes Kabel der ersten und zweiten Leitung mit dem ersten Cage Clamp Anschluss oder Schraubanschluss verbunden und das zweite Kabel der ersten und zweiten Leitung mit dem zweiten Cage Clamp Anschluss oder Schraubanschluss verbunden.

Sobald die Kabel mit dem jeweiligen Anschluss des Anschlussmittels verbunden sind, sind sie sowohl in dem mechanisch verbunden Zustand des zweiten Verbindungsmoduls mit dem Feldgeräte als auch in dem mechanisch getrennten Zustand des zweiten Verbindungsmoduls mit dem Feldgeräte elektrisch leitend miteinander Verbunden. Das erste Kabel der ersten Leitung ist stets mit dem ersten Kabel der zweiten Leitung verbunden. Das zweite Kabel der ersten Leitung ist stets mit dem zweiten Kabel der zweiten Leitung verbunden. Hierdurch kann die Kommunikation des Feldbusses über die Kabel der beiden Leitungen trotz Trennung des zweiten Verbindungsmoduls vom Feldgerät aufrechterhalten und sichergestellt werden.

Durch das mechanische Verbinden des zweiten Verbindungsmoduls mit dem Feldgerät erfolgt automatisch eine elektrische Verbindung des ersten und zweiten Cage Clamp Anschlusses oder Schraubanschlusses mit einer zugehörigen Kontaktstelle am Feldgerät. Im mechanisch verbundenen Zustand des zweiten Verbindungsmoduls mit dem Feldgerät liegt somit eine elektrisch leitende Verbindung zwischen den angeschlossenen Kabeln und dem Feldgerät vor. Über das zweite Verbindungsmittel wird insbesondere eine elektrisch leitende Verbindung zwischen den ersten Kabeln der Leitungen mit einer ersten Kontaktstelle des Feldgerätes und den zweiten Kabeln der Leitungen mit einer zweiten Kontaktstelle des Feldgerätes hergestellt.

In einer weiteren vorteilhaften Ausführungsform der Erfindung weist das Anschlussmittel des zweiten Verbindungsmoduls für den Schirmanbindungsleiter eine Anschlussstelle auf.

Der Schirmanbindungsleiter des ersten Verbindungsmoduls kann an der Anschlussstelle des Anschlussmittels mechanisch und elektrisch mit dem zweiten Verbindungsmodul verbunden werden. Durch das mechanische Verbinden des zweiten Verbindungsmoduls mit dem Feldgerät erfolgt automatisch eine elektrische Verbindung des am zweiten Verbindungsmodul angeschlossenen Schirmanbindungsleiters mit einer dritten Kontaktstelle am Feldgerät. Eine elektrische Verbindung des Feldgerätes zum Leitungsschirm der mit dem ersten Verbindungsmodul verbundenen Leitungen wird hierdurch hergestellt.

In einer weiteren vorteilhaften Ausführungsform der Erfindung umfasst das zweite Verbindungsmodul zum mechanischen und elektrischen Anschließen des Schirmanbindungsleiters einen dritten Cage Clamp Anschluss oder einen dritten Schraubanschluss. Durch das mechanische Verbinden des zweiten Verbindungsmoduls mit dem zweiten Anschlussmittels des Feldgeräts erfolgt automatisch eine elektrische Verbindung des dritten Cage Clamp Anschlusses oder dritten Schraubanschlusses mit der dritten Kontaktstelle am Feldgerät.

In einer weiteren vorteilhaften Ausführungsform der Erfindung ist das zweite Verbindungsmodul durch drei separat ausgebildete Anschlussmodule ausgebildet, welche jeweils getrennt voneinander mechanisch mit dem Feldgerät verbindbar sind, wobei das erste Anschlussmodul den ersten Cage Clamp Anschluss oder ersten Schraubanschluss umfasst, das zweite Anschlussmodul den zweiten Cage Clamp Anschluss oder zweiten Schraubanschluss umfasst und das dritte Anschlussmodul den dritten Cage Clamp Anschluss oder dritte Schraubanschluss umfasst.

Durch das mechanische Verbinden des ersten Anschlussmoduls mit dem Feldgerät erfolgt automatisch eine elektrische Verbindung des ersten Cage Clamp Anschlusses oder ersten Schraubanschlusses mit der ersten Kontaktstelle am Feldgerät.

Durch das mechanische Verbinden des zweiten Anschlussmoduls mit dem Feldgerät erfolgt automatisch eine elektrische Verbindung des zweiten Cage Clamp Anschlusses oder zweiten Schraubanschlusses mit der zweiten Kontaktstelle am Feldgerät.

Durch das mechanische Verbinden des dritten Anschlussmoduls mit dem Feldgerät erfolgt automatisch eine elektrische Verbindung des dritten Cage Clamp Anschlusses oder dritten Schraubanschlusses mit einer dritten Kontaktstelle am Feldgerät. Ein am dritten Cage Clamp Anschluss oder Schraubanschluss angeschlossener Schirmanbindungsleiter wird somit durch das mechanische Koppeln des dritten Anschlussmoduls mit dem Feldgerät elektrisch leitend mit der dritten Kontaktstelle des Feldgerätes verbunden.

Die elektrisch leitende Verbindung der Kabel zu der zugehörigen Kontaktstelle des Feldgerätes erfolgt insbesondere über eine im jeweiligen Anschlussmodul geführte elektrisch leitende Verbindung.

In einer weiteren vorteilhaften Ausführungsform der Erfindung ist das Feldgerät ein Gerät zum Schutz und/oder zur Steuerung von Elektromotoren.

Das Feldgerät ist vorzugsweise ein Motormanagementsystem. Das Motormanagementsystem überwacht vorzugsweise Strom- und/oder Spannungswerte des Versorgungsstrangs zu einem Elektromotor und kann über ein im Versorgungsstrang zwischengeschaltetes Schütz die Energieversorgung zum Elektromotor steuern.

Der Feldbus ist beispielsweise ein PROFIBUS, welcher Standard für die Feldbus-Kommunikation in der Automatisierungstechnik ist. Vorzugsweise ist der Feldbus ein PROFIBUS DP Feldbus. Mittels PROFIBUS DP werden in der Fertigungstechnik durch eine zentrale Steuerung Feldgeräte (Motormanagementsysteme, Sensoren und/oder Aktoren) angesteuert. Die Feldbusleitung umfasst vorzugsweise lediglich zwei Kabel, welche von einem Schirm umgeben sind.

In einer weiteren vorteilhaften Ausführungsform der Erfindung liegt ein System vor, welches das Feldgerät, eine speicherprogrammierbare Steuerung und eine Schütz, welches in den Versorgungsstrang zu einem Elektromotor zwischengeschaltet ist, umfasst. Der Feldbus der SPS ist mittels des ersten und zweiten Verbindungsmoduls mit dem Feldgerät verbunden. Das Feldgerät ist über das Anschlussmittel des zweiten Verbindungsmoduls mit dem Feldbus der speicherprogrammierbaren Steuerung verbunden und kann über das Schütz den Elektromotor steuern.

Durch das Feldgerät wird ein umfassender Schutz des Motorabzweigs ermöglicht. Das Feldgerät kann vorzugsweise Strom- und/oder Spannungswerte des Versorgungsstrangs zum Elektromotor erfassen und auswerten und ermöglicht hierüber für den Elektromotor des Motorabzweiges:
- einen Überlastschutz,
- einen Thermistor-Motorschutz,
- einen Phasenausfall-/ Unsymmetrieschutz,
- einen Blockierschutz,
- eine Überwachung einstellbarer Grenzwerte für den Motorstrom,
- eine Spannungsüberwachung,
- eine Leistungsüberwachung,
- eine Überwachung des cos phi (Motorleerlauf / Lastabwurf),
- eine Erdschlussüberwachung,
- eine Temperaturüberwachung,
- eine Überwachung von Betriebsstunden,
- eine Überwachung von Stillstandzeiten des Elektromotors,
- eine Überwachung der Anzahl der Starts des Elektromotors innerhalb eines Zeitfensters, und/oder
- eine sicherheitsgerichtete Abschaltung von Motorabzweigen, lokal oder über PROFISAFE.

Im Folgenden werden die Erfindung und Ausgestaltungen der Erfindung anhand der in den Figuren dargestellten Ausführungsbeispiele näher beschrieben und erläutert. Es zeigen:
- FIG 1: eine schematische Darstellung eines Systems zum Steuern und Schützen eines Elektromotors,
- FIG 2: eine schematische Darstellung des Feldgerätes aus FIG 1,
- FIG 3: eine schematische Darstellung eines ersten Verbindungsmittels,
- FIG 4: eine schematische Darstellung des Feldgerätes aus FIG 2, an welches zwei Feldbusleitungen anzuschließen sind, und
- FIG 5: eine schematische Darstellung des Feldgerätes aus FIG 4, welches ordnungsgemäß an den Feldbus angebunden ist.

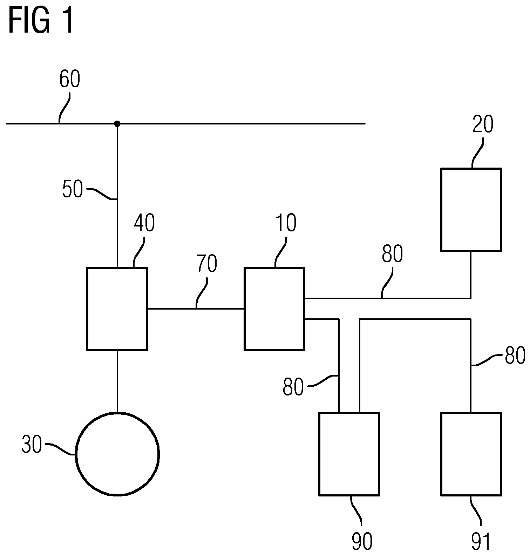

FIG 1 zeigt eine schematische Darstellung eines Systems zum Steuern und Schützen eines Elektromotors 30. Der Elektromotor 30 ist über einen Motorabzweig 50 mit einem Versorgungsnetz 60 verbunden. Dem Elektromotor 30 ist innerhalb des Motorabzweiges 50 ein Schütz 40 vorgeschaltet. Über das Schütz 40 kann die Energieversorgung des Elektromotors 30 gesteuert werden. Das Schütz 40 kann die über den Motorabzweig 50 erfolgende Energieversorgung zum Elektromotor 30 herstellen und unterbrechen. Das Versorgungsnetz 60 ist ein Niederspannungsnetz, welches drei Phasen umfasst. Der Elektromotor 30 ist ein Drehstrommotor.

Das Schütz 40 ist über eine Kommunikationsleitung 70 mit einem Feldgerät 10 verbunden. Das Feldgerät 10 kann hierüber das Schütz 40 steuern; d.h. ein- und ausschalten. Ferner kann das Feldgerät 10 über eine nicht abgebildete separate Messvorrichtung Strom- und Spannungswerte des Motorabzweiges 50 erfassen. Diese Messvorrichtung ist beispielsweise innerhalb des Motorabzweigs 50 zwischen dem Schütz 40 und dem Elektromotor 30 angeordnet und mit dem Feldgerät 10 verbunden, so dass das Feldgerät 10 über die Messvorrichtung die vorliegenden Strom- und Spannungswerte des Motorabzweiges 50 erfassen kann. Durch eine Auswertung der Strom- und Spannungswerte des Motorabzweiges 50 kann das Feldgerät 10 einen Rückschluss auf den Betriebszustand des Elektromotors 30 gewinnen. Insbesondere ermöglicht das Feldgerät 10, welches ein Motormanagementsystem ist, für den Elektromotor 30:
- einen Überlastschutz,
- einen Thermistor-Motorschutz,
- einen Phasenausfall-/ Unsymmetrieschutz,
- einen Blockierschutz,
- eine Überwachung einstellbarer Grenzwerte für den Motorstrom,
- eine Spannungsüberwachung,
- eine Leistungsüberwachung,
- eine Überwachung des cos phi (Motorleerlauf / Lastabwurf),
- eine Erdschlussüberwachung,
- eine Temperaturüberwachung,
- eine Überwachung von Betriebsstunden,
- eine Überwachung von Stillstandzeiten des Elektromotors,
- eine Überwachung der Anzahl der Starts des Elektromotors innerhalb eines Zeitfensters, und/oder
- eine sicherheitsgerichtete Abschaltung von Motorabzweigen, lokal oder über PROFISAFE.

Ermittelt das Feldgerät 10 durch die Auswertung der Strom- und/oder Spannungswerte für den Elektromotor 30 ein kritischer Zustand, so öffnet das Feldgerät 10 das Schütz 40, so dass die Energieversorgung des Elektromotors 30 unterbrochen wird. Ein sicherer Zustand wird folglich herbeigeführt.

Zur Einbindung des Feldgerätes 10 in ein Automatisierungssystem ist das Feldgerät 10 über einen Feldbus 80 mit einer speicherprogrammierbaren Steuerung 20 verbunden. Über diese kommunikative Verbindung können der SPS 20 beispielsweise der Betriebszustand des Elektromotors 30 oder Diagnosedaten (z.B. Stillstandzeiten, Betriebsstunden) zum Elektromotor 30 übermittelt werden, so dass durch die SPS eine übergeordnete Auswertung des Motorabzweigs 50 erfolgen kann. Hierdurch wird eine optimierte Überwachung und Analyse des Automatisierungssystems ermöglicht. Die Kommunikation zwischen der SPS 20 und dem Feldgerät 10 erfolgt mittels des Feldbussystems PROFIBUS DP. Hierfür ist das Feldgerät 10 über den PROFIBUS DP Feldbus 80 mit der SPS 20 verbunden.

Innerhalb des Automatisierungssystems sind ferner zwei weitere PROFIBUS Feldgeräte 90, 91 über den Feldbus 80 mit der Steuerung 20 verbunden.

Der PROFIBUS DP Feldbus 80 ist in Linientopologie ausgebildet. Bei einem in Linientopologie ausgebildeten Feldbussystem werden bis auf das letzte Feldgerät 91 zu den einzelnen Feldgeräten 10, 90 jeweils zwei PROFINET DP Feldbusleitung geführt (eine "kommende" und eine "gehende" Feldbusleitung). Am jeweiligen Feldgerät 10, 90 müssen folglich jeweils zwei Feldbusleitungen angeschlossen werden. Das letzte Feldgerät 91 weist einen Busabschluss auf.

Die PROFIBUS DP Feldbusleitung umfasst jeweils zwei Kabel, welche von einem Leitungsschirm und einer Isolierung umgeben sind.

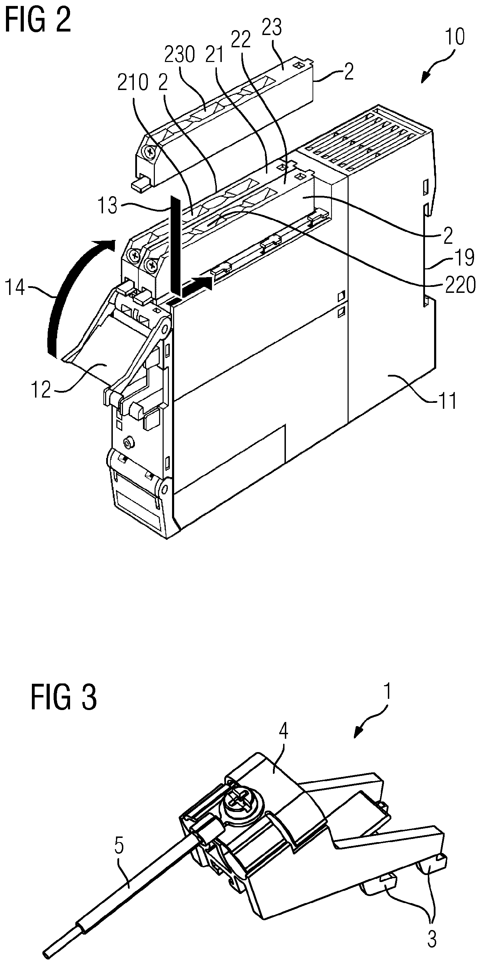

FIG 2 zeigt eine schematische Darstellung des Feldgerätes 10 aus FIG 1, mittels welchem der Elektromotor gesteuert und geschützt wird. Das Feldgerät 10 ist modular aufgebaut und weist ein Grundmodul 11 und ein zweites Verbindungsmodul 2 auf. Im Grundmodul 11 ist insbesondere die Logik des Feldgerätes 10 untergebracht. Das zweite Verbindungsmodul 2 dient dem elektrischen Anschluss der Kabel der beiden Feldbusleitungen und dem elektrischen Anschluss eines Schirmanbindungsleiters.

Das zweite Verbindungsmodul 2 ist durch drei separat ausgebildete Anschlussmodule 21, 22, 23 ausgebildet, welche jeweils getrennt voneinander mechanisch mit dem Feldgerät 10 verbindbar sind.

Das erste Anschlussmodul 21 umfasst einen ersten Schraubanschluss 210, an welchen ein erstes Kabel der ersten und zweiten Feldbusleitung angeschlossen werden kann. Der erste Schraubenanschluss 210 könnte ebenso als Cage Clamp Anschluss ausgebildet sein.

Das zweite Anschlussmodul 22 umfasst einen zweiten Schraubanschluss 220, an welchen ein zweites Kabel der ersten und zweiten Feldbusleitung angeschlossen werden kann. Der zweite Schraubenanschluss 220 könnte ebenso als Cage Clamp Anschluss ausgebildet sein.

Das dritte Anschlussmodul 23 umfasst einen dritten Schraubanschluss 230, an welchen der Schirmanbindungsleiter angeschlossen werden kann. Der dritte Schraubenanschluss 230 könnte ebenso als Cage Clamp Anschluss ausgebildet sein.

Durch das mechanische Verbinden des ersten Anschlussmoduls 21 mit dem Grundmodul 11 des Feldgeräts 10 erfolgt automatisch eine elektrische Verbindung des ersten Schraubanschlusses 210 mit einer ersten Kontaktstelle am Grundmodul 11 des Feldgerätes 10. Die am ersten Schraubanschluss 210 angeschlossenen ersten Kabel der Leiter werden somit durch das mechanische Koppeln des ersten Anschlussmoduls 21 mit dem Grundmodul 11 elektrisch leitend mit der ersten Kontaktstelle des Grundmoduls 11 des Feldgerätes 10 verbunden.

Durch das mechanische Verbinden des zweiten Anschlussmoduls 22 mit dem Grundmodul 11 des Feldgeräts 10 erfolgt automatisch eine elektrische Verbindung des zweiten Schraubanschlusses 220 mit einer zweiten Kontaktstelle am Grundmodul 11 des Feldgerätes 10. Die am zweiten Schraubanschluss 220 angeschlossenen zweiten Kabel der Leiter werden somit durch das mechanische Koppeln des zweiten Anschlussmoduls 22 mit dem Grundmodul 11 des Feldgeräts 10 elektrisch leitend mit der zweiten Kontaktstelle des Grundmoduls 11 des Feldgerätes 10 verbunden.

Durch das mechanische Verbinden des dritten Anschlussmoduls 22 mit dem Grundmodul 11 des Feldgeräts 10 erfolgt automatisch eine elektrische Verbindung des dritten Schraubanschlusses 230 mit einer dritten Kontaktstelle am Grundmodul 11 des Feldgerätes 10. Ein am dritten Schraubanschluss 230 angeschlossener Schirmanbindungsleiter wird somit durch das mechanische Koppeln des dritten Anschlussmoduls 23 mit dem Grundmodul 11 des Feldgeräts 10 elektrisch leitend mit der dritten Kontaktstelle des Grundmoduls 11 des Feldgerätes 10 verbunden.

Die elektrisch leitende Verbindung der am Schraubenanschluss 210, 220, 230 angeschlossenen Kabel zu der zugehörigen Kontaktstelle des Grundmoduls 11 des Feldgerätes 10 erfolgt über eine im jeweiligen Anschlussmodul 21, 22, 23 geführte elektrisch leitende Verbindung.

Das zweite Verbindungsmodul 2 bzw. dessen Anschlussmodule 21,22,23 können getrennt voneinander über ein am Grundmodul 11 des Feldgerätes 10 angeordnetes zweites Aufnahmemittel mit dem Feldgerät 10 verrastet werden, so dass eine mechanisch stabile Verbindung zwischen dem Grundmodul 11 des Feldgeräts 10 und dem jeweiligen Anschlussmodul 21, 22, 23 des zweiten Verbindungsmoduls 2 vorliegt. Diese mechanische Verbindung kann ohne Zuhilfenahme eines Werkzeuges seitens eines Installateurs hergestellt werden.

Die formschlüssige Verbindung des zweiten Verbindungsmoduls 2 mit dem Grundmodul 11 des Feldgeräts 10 über das zweite Aufnahmemittel ist eine mechanisch zerstörungsfreie lösbare Verbindung, so dass ein Lösen der einzelnen Anschlussmodule 21, 22, 23 vom Grundmodul 11 und ein erneutes mechanisches Verbinden der Anschlussmodule 21, 22, 23 mit dem Grundmodul 11 erfolgen kann.

Im mechanisch verbundenen Zustand des zweiten Verbindungsmoduls 2 mit dem Grundmodul 11 des Feldgerätes 10 liegt eine elektrisch leitende Verbindung zwischen den angeschlossenen Kabeln und den Kontaktstellen des Grundmoduls 11 des Feldgerätes 10 vor.

Am ersten Schraubenanschluss 210 angeschlossene erste Kabel der Feldbusleitungen sind mit der ersten Kontaktstelle des Grundmoduls 11, am zweiten Schraubenanschluss 220 angeschlossene zweite Kabel der Feldbusleitungen sind mit der zweiten Kontaktstelle des Grundmoduls 11 und ein am dritten Schraubenanschluss 230 angeschlossener Schirmanbindungsleiter ist mit der dritten Kontaktstelle des Grundmoduls 11 elektrisch leitend verbunden.

Das mechanische Verbinden der einzelnen Anschlussmodule 21, 22, 23 mit dem Grundmodul 11 des Feldgerätes 10 erfolgt mittels einer Rastverbindung. Hierfür wird das jeweilige Anschlussmodul 21, 22, 23, wie mit dem ersten Pfeil 13 angedeutet, auf das Grundmodul 11 aufgeschoben, bis dieses durch entsprechende Rastelemente am Anschlussmodul 21, 22, 23 und am zweiten Aufnahmekörper des Grundmoduls 11 mit dem Grundmodul 11 verrastet. In der Abbildung ist bereits das erste und zweite Anschlussmodul 21, 22 mit dem Grundmodul 11 mechanisch verbunden, so dass eine elektrische Kontaktierung zwischen deren Schraubanschluss 210, 220 zum Grundmodul 11 hergestellt ist. Das dritte Anschlussmodul 23 ist abgesetzt vom Grundmodul 11 dargestellt. Nachdem ebenso das dritte Anschlussmodul 23 mit dem Grundmodul 11 mechanisch verbunden wurde, erfolgt durch ein hochklappen einer Kappe 12 des Grundmoduls 11 (wie durch den zweiten Pfeil 14 angedeutet) eine zusätzliche mechanische Befestigung der Anschlussmodule 21, 22, 23 mit dem Grundmodul 11 statt.

Das Feldgerät 10 weist ein Hutschienenverbindungsmittel 19 auf, mittels welchem das Feldgerät 10 mit einer Hutschiene mechanisch verbunden werden kann. Diese mechanische Verbindung ist eine lösbare Verbindung.

FIG 3 zeigt eine schematische Darstellung eines ersten Verbindungsmoduls 1. Das erste Verbindungsmodul 1 umfasst ein erstes Verbindungsmittel 3 und ein zweites Verbindungsmittel 4. Das erste Verbindungsmittel 3 dient dem mechanischen Verbinden des ersten Verbindungsmoduls 1 mit einem in FIG 2 dargestellten Feldgerät. Das zweite Verbindungsmittel 4 dient der mechanischen Fixierung der beiden PROFINET DP Feldbusleitungen mit dem ersten Verbindungsmodul 1 sowie der elektrischen Kontaktierung des Leitungsschirms der beiden PROFINET DP Feldbusleitungen mit einem Schirmanbindungsleiter 5. Der Schirmanbindungsleiter 5 ist teilweise als Kabel ausgebildet.

Das zweite Verbindungsmittel 4 ist als Klemme ausgebildet, mittels welcher die beiden PROFINET DP Feldbusleitungen am ersten Verbindungsmodul 1 fixiert werden können. Die Klemme ist mittels einer Schraube verstellbar, so dass hierüber die beiden zwischen die Klemme eingelegten Feldbusleitungen festgeklemmt und somit fixiert werden können.

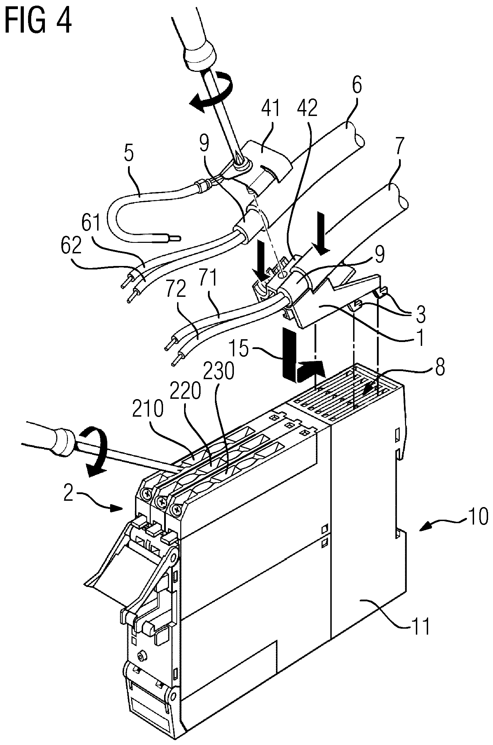

FIG 4 zeigt eine schematische Darstellung des Feldgerätes 10 aus FIG 2, an welches zwei PROFINET DP Feldbusleitungen 6, 7 anzuschließen sind. Die erste Feldbusleitung 6 umfasst ein erstes Kabel 61 und ein zweites Kabel 62. Die zweite Feldbusleitung 7 umfasst ein erstes Kabel 71 und ein zweites Kabel 72.

Die beiden PROFINET DP Feldbusleitungen 6, 7 weisen jeweils einen Leitungsschirm 9 auf, welcher die beiden Kabel 61, 62 bzw. 71, 72 umgibt. Zum Verbinden der beiden PROFINET DP Feldbusleitungen 6, 7 mit dem ersten Verbindungsmodul 1 aus Figur 3 wird die äußere elektrische Isolierung der Feldbusleitungen 6, 7 im Kontaktbereich mit dem zweiten Verbindungsmittel und somit mit der Klemme entfernt, so dass der Leitungsschirm 9 zugänglich ist.

Die Endstücke der beiden Feldbusleitungen sind insbesondere derart bearbeitet, dass:
- jeweils die Kabel 61, 62, 71, 72 für ca. 4,7 cm von der äußeren elektrischen Isolierung sowie vom Leitungsschirm 9 freigelegt sind,
- die Isolation am Ende der Kabel 61, 62, 71, 72 für ca. 1 cm entfernt ist,
- der Leitungsschirm für ca. 1 cm außen anliegt, bevor die äußere elektrische Isolierung die Leitung 6, 7 umgibt.

Die Klemme ist an der zur Feldbusleitung gerichteten Seite (Schirmkontaktseite) elektrisch leitend und kann hierüber eine elektrisch leitende Verbindung zu den Leitungsschirmen 9 der Feldbusleitungen 6, 7 herstellen. Ferner ist die Klemme mit dem Schirmanbindungsleiter 5 verbunden und stellt eine elektrisch leitende Verbindung des Schirmanbindungsleiters 5 zur Schirmkontaktseite her, so dass der Schirmanbindungsleiter 5 elektrisch leitenden mit dem Leitungsschirm 9 der beiden Leitungen 6, 7, welche über die Klemme fixiert werden, verbunden ist. Zum Fixieren der beiden Leitungen 6,7 werden diese in die Klemme eingelegt. Durch das Festziehen einer Schraube der Klemme wird der obere Teil 41 der Klemme in Richtung des unteren Teils 42 der Klemme bewegt, so dass letztendlich die Leitungen 6, 7 am ersten Verbindungsmodul 1 fixiert werden.

Ein erstes Ende des Schirmanbindungsleiters 5 ist über die Schraube der Klemme am Oberen Teil 41 der Klemme mechanisch und elektrisch angeschlossen.

Zum ordnungsgemäßen Anschließen der Feldbusleitungen 6, 7 am Feldgerät 1 wird das zweite Verbindungsmittel 2 mit dem Grundmodul 11 des Feldgerätes 10 verbunden. Ferner werden die Leitungen 6, 7 über das zweite Verbindungsmittel 4 am ersten Verbindungsmodul 1 mechanisch fixiert. Hierbei muss der Leitungsschirm 9 der beiden Leitungen 6,7 die Klemme elektrisch kontaktieren.

Anschließend wird das zweite Ende des Schirmanbindungsleiters 5 am dritten Schraubanschluss 230 des zweiten Verbindungsmoduls 2 mechanisch und elektrisch angeschlossen. Ebenso werden die ersten Kabel 61, 71 der ersten und zweiten Leitung 6, 7 am ersten Schraubanschluss 210 des zweiten Verbindungsmoduls 2 mechanisch und elektrisch angeschlossen. Die zweiten Kabel 62, 72 der ersten und zweiten Leitung 6, 7 werden am zweiten Schraubanschluss 220 des zweiten Verbindungsmoduls 2 mechanisch und elektrisch angeschlossen.

Anschließend wird das erste Verbindungsmodul 1 mittels des ersten Verbindungsmittels 5 mit dem Feldgerät 10 mechanisch verbunden. Das Feldgerät 10 weist zur mechanischen Verbindung mit dem ersten Verbindungsmodul 1 ein erstes Aufnahmemittel 8 auf. Die mechanische Verbindung zwischen dem ersten Aufnahmemittel 8 und dem ersten Verbindungsmittel 3 des ersten Verbindungsmoduls 1 ist eine formschlüssige Verbindung. Das erste Verbindungsmodul 1 kann mittels des ersten Verbindungsmittels 3 mit dem ersten Aufnahmemittel 8 verrastet werden, so dass das erste Verbindungsmodul 1 am Feldgerät 10 mechanisch fixiert ist. Der Bewegungsablauf der Verrastung des ersten Verbindungsmoduls 1 mit dem Feldgerät 10 ist mittels des dritten Pfeils 15 angedeutet.

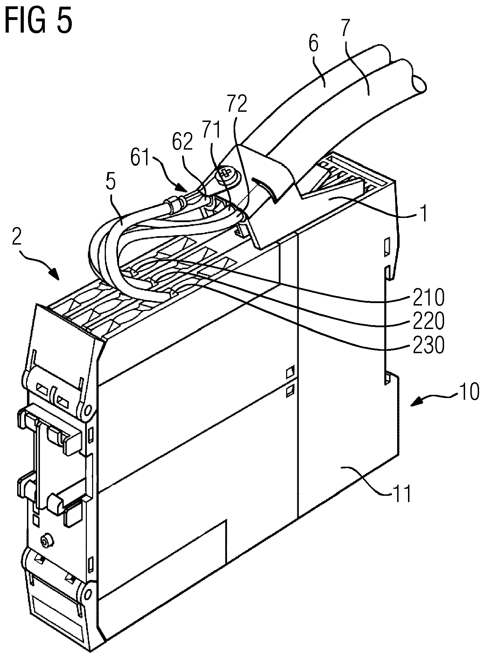

FIG 5 zeigt eine schematische Darstellung des Feldgerätes 10 aus FIG 4, welches ordnungsgemäß an den Feldbus angebunden ist. Das Feldgerät 10 ist mittels des ersten und zweiten Verbindungsmoduls 1, 2 elektrisch und mechanisch mit der ersten und zweiten Feldbusleitung 6,7 verbunden, so dass hierüber eine Kommunikation mit der SPS erfolgen kann.

Das erste Verbindungsmodul 1 dient lediglich der mechanischen Fixierung der beiden Leitungen 6, 7 mit dem Grundmosul 11 des Feldgerätes 11 und der Kontaktierung des Leitungsschirms der beiden Leitungen 6, 7 mit dem Schirmanbindungsleiter 5. Über ein durch das zweite Verbindungsmittel 4 ausgebildete Geräteklemme wird der Schirm der Leitungen 6,7 mit dem Schirmanbindungsleiter 5 elektrisch leitend verbunden.

Die Kontaktierung der ersten und zweiten Kabel 61, 62, 71, 72 der Feldbusleitungen 6, 7 sowie des Schirmanbindungsleiters 5 erfolgt direkt an den vorhandenen, vom Grundmosul 11 abnehmbaren Anschlussmodulen des zweiten Verbindungsmoduls 2.

Im Fall eines Tausches des Feldgerätes 10 wird das erste und zweite Verbindungsmodul 1, 2 vom Grundmodul 11 des Feldgerätes 10 getrennt. Dadurch, dass die ersten Kabel 61, 71 der Leitungen 6, 7 über das erste Anschlussmodul des zweiten Verbindungsmoduls 2 sowie die zweiten Kabel 62, 72 der Leitungen 6, 7 über das zweiten Anschlussmodul des zweiten Verbindungsmoduls 2 weiterhin elektrisch miteinander verbunden sind wird die Kommunikation auf dem Feldbus nicht unterbrochen. Die Verbindung der Feldbusleitung 6, 7 erfolgt weiterhin über das abgenommene zweite Verbindungsmodul 2. Bei einem neuen baugleichen Feldgerät 10 muss lediglich das erste und zweite Verbindungsmodul 1, 2 mit diesem verbunden werden, so dass ein Austausch des Feldgerätes 10 stattgefunden hat Vorteile des ersten und zweiten Verbindungsmoduls 1, 2 bestehen insbesondere darin, dass das erste und zweite Verbindungsmodul 1, 2 kostengünstig hergestellt werden kann und zudem eine verbesserte Anbindung der Feldbusleitungen 6, 7 an das Feldgerät 10 ermöglicht wird. Die Position der Anschlussstellen (hier erster, zweiter und dritter Schraubanschluss 210, 220, 230) für die Kabel 61, 62, 71, 72 der Feldbusleitung 6, 7 und des Schirmanbindungsleiters 5 kann flexibel am Feldgerät 10 gestaltet werden.

Üblicherweise hat ein Feldgerät auf einer Seite mehrere Anschlussstellen für Kabel. Nur drei davon werden für den Feldbusanschluss verwendet. Durch die Trennung der mechanischen Verbindung der Feldbusleitungen 6, 7 am Feldgerät 10 mittels des ersten Verbindungsmoduls 1 von der elektrischen Kontaktierung der Kabel 61, 62, 71, 72 der Feldbusleitungen 6, 7 mit dem Feldgerät 10 mittels des zweiten Verbindungsmoduls 2 wird eine äußerst flexiblere Anordnung der Anschlussstellen 210, 220, 230 des Anschlussmittels für die Kabel 61, 62, 71, 72 der Feldbusleitungen 6, 7 ermöglicht.

## Patentansprüche

1. Anordnung zum Anbinden eines Feldgeräts (10) an einen Feldbus (80), umfassend ein erstes und zweites Verbindungsmodul (1, 2), wobei das erste Verbindungsmodul (1) ein erstes und zweites Verbindungsmittel (3, 4) umfasst, wobei das erste Verbindungsmittel (3) dem mechanischen Verbinden des ersten Verbindungsmoduls (1) mit dem Feldgerät (10) dient, das zweite Verbindungsmittel (4) der mechanischen Fixierung zweier Feldbusleitungen (6, 7), mit dem ersten Verbindungsmodul (1) und der elektrischen Kontaktierung jeweils eines Leitungsschirms (9) der beiden Feldbusleitungen (6, 7) mit einem Schirmanbindungsleiter (5) dient, wobei das zweite Verbindungsmodul (2) getrennt vom ersten Verbindungsmodul (1) mit dem Feldgerät (10) mechanisch und elektrisch verbindbar ist, wobei das zweite Verbindungsmodul (2) ein Anschlussmittel 210**,** 220, 230) umfasst, über welches Kabel (61, 62, 71, 72) der beiden Feldbusleitungen (6, 7) mechanisch und elektrisch mit dem zweiten Verbindungsmodul (2) verbindbar sind, wobei das zweite Verbindungsmodul (2) derart ausgebildet ist, dass im mechanisch verbundenen Zustand des zweiten Verbindungsmoduls (2) mit dem Feldgerät (10) die Kabel (61, 62, 71, 72) elektrisch leitend mit dem Feldgerät (10) verbunden sind, **dadurch gekennzeichnet, dass** das zweite Verbindungsmodul (2) zu einem Verbinden der Feldbusleitungen (6, 7) zur Kommunikation in einem von einem Grundmodul (11) des Feldgeräts (10) getrennten Zustand ausgebildet ist.

2. Anordnung nach Anspruch 1, wobei die Anordnung das Feldgerät (10) umfasst.

3. Anordnung nach Anspruch 2, wobei das Feldgerät (10) zur mechanischen Verbindung mit dem zweiten Verbindungsmodul (2) ein zweites Aufnahmemittel umfasst, wobei die mechanische Verbindung zwischen dem zweiten Aufnahmemittel und dem zweiten Verbindungsmodul (2) eine formschlüssige Verbindung ist.

4. Anordnung nach Anspruch 2 oder 3, wobei das Feldgerät (10) zur mechanischen Verbindung mit dem ersten Verbindungsmodul (1) ein erstes Aufnahmemittel (8) umfasst, wobei die mechanische Verbindung zwischen dem ersten Aufnahmemittel (8) und dem ersten Verbindungsmittel (3) des ersten Verbindungsmoduls (1) eine formschlüssige Verbindung ist.

5. Anordnung nach Anspruch 3 und 4, wobei sich das erste und zweite Aufnahmemittel (8) auf der gleichen Seitenfläche des Feldgerätes (10) befindet.

6. Anordnung nach einem der vorhergehenden Ansprüche, wobei das Anschlussmittel mindestens ein Cage Clamp Anschluss oder ein Schraubanschluss (210, 220, 230) umfasst.

7. Anordnung nach Anspruch 6, wobei das Anschlussmittel einen ersten und zweiten Cage Clamp Anschluss oder einen ersten und zweiten Schraubanschluss (210, 220) aufweist.

8. Anordnung nach einem der vorhergehenden Ansprüche, wobei das Anschlussmittel für den Schirmanbindungsleiter (5) eine Anschlussstelle (230) aufweist.

9. Anordnung nach Anspruch 8, wobei das zweite Verbindungsmodul (2) zum mechanischen und elektrischen Anschließen des Schirmanbindungsleiters (5) einen dritten Cage Clamp Anschluss oder einen dritten Schraubanschluss (230) umfasst.

10. Anordnung nach Anspruch 7 und 9, wobei das zweite Verbindungsmodul (2) durch drei separat ausgebildete Anschlussmodule (21, 22, 23) ausgebildet ist, welche jeweils getrennt voneinander mechanisch mit dem Feldgerät (10) verbindbar sind, wobei das erste Anschlussmodul (21) den ersten Cage Clamp Anschluss oder ersten Schraubanschluss (210) umfasst, das zweite Anschlussmodul (22) den zweiten Cage Clamp Anschluss oder zweiten Schraubanschluss (220) umfasst und das dritte Anschlussmodul (23) den dritten Cage Clamp Anschluss oder dritte Schraubanschluss (230) umfasst.

11. Anordnung nach einem der vorhergehenden Ansprüche, wobei das Feldgerät (10) ein Gerät zum Schutz und/oder zur Steuerung von Elektromotoren (30) ist.

12. System mit einer Anordnung nach einem der vorhergehenden Ansprüche, einer speicherprogrammierbaren Steuerung (20) und einem Schütz (40), welches in den Versorgungsstrang (50) zu einem Elektromotor (30) zwischengeschaltet ist, wobei das Feldgerät (10) über das Anschlussmittel des zweiten Verbindungsmoduls (2) mit dem Feldbus (80) der speicherprogrammierbaren Steuerung (20) verbunden ist und über das Schütz (40) den Elektromotor (30) steuern kann.

## Claims

1. Arrangement for connecting a field device (10) to a field bus (80), comprising a first and second connection module (1, 2), wherein the first connection module (1) comprises a first and second connection means (3, 4), wherein the first connection means (3) is used to mechanically connect the first connection module (1) to the field device (10), the second connection means (4) is used to mechanically fix two field bus lines (6, 7) to the first connection module (1) and to bring a line shield (9) of each of the two field bus lines (6, 7) into electrical contact with a shield connection conductor (5), wherein the second connection module (2) can be mechanically and electrically connected to the field device (10) separately from the first connection module (1), wherein the second connection module (2) comprises a connection means (210, 220, 230), by means of which cables (61, 62, 71, 72) of the two field bus lines (6, 7) can be mechanically and electrically connected to the second connection module (2), wherein the second connection module (2) is designed such that in the mechanically connected state of the second connection module (2) to the field device (10), the cables (61, 62, 71, 72) are connected to the field device (10) in an electrically conductive manner, **characterised in that** the second connection module (2) is designed to connect the field bus lines (6, 7) for communication in a state separate from a basic module (11) of the field device (10).

2. Arrangement according to claim 1, wherein the arrangement comprises the field device (10).

3. Arrangement according to claim 2, wherein the field device (10) comprises a second receiving means for mechanical connection to the second connection module (2), wherein the mechanical connection between the second receiving means and the second connection module (2) is a form-fit connection.

4. Arrangement according to claim 2 or 3, wherein the field device (10) comprises a first receiving means (8) for mechanical connection to the first connection module (1), wherein the mechanical connection between the first receiving means (8) and the first connection means (3) of the first connection module (1) is a form-fit connection.

5. Arrangement according to claim 3 and 4, wherein the first and second receiving means (8) are located on the same lateral surface of the field device (10).

6. Arrangement according to one of the preceding claims, wherein the connection means comprises at least one cage clamp connection or a screw connection (210, 220, 230).

7. Arrangement according to claim 6, wherein the connection means has a first and second cage clamp connection or a first and second screw connection (210, 220).

8. Arrangement according to one of the preceding claims, wherein the connection means has a connection point (230) for the screen connection conductor (5).

9. Arrangement according to claim 8, wherein the second connection module (2) comprises a third cage clamp connection or a third screw connection (230) for mechanically and electrically connecting the shield connection conductor (5).

10. Arrangement according to claim 7 and 9, wherein the second connection module (2) is formed by three separately formed connector modules (21, 22, 23), which can be connected to the field device (10) mechanically separate from one another in each case, wherein the first connection module (21) comprises the first cage clamp connection or first screw connection (210), the second connection module (22) comprises the second cage clamp connection or second screw connection (220) and the third connection module (23) comprises the third cage clamp connection or third screw connection (230).

11. Arrangement according to one of the preceding claims, wherein the field device (10) is a device for the protection and/or control of electric motors (30).

12. System having an arrangement according to one of the preceding claims, a programmable controller (20) and a contactor (40) which is interposed in the supply line (50) to an electric motor (30), wherein the field device (10) is connected to the field bus (80) of the programmable controller (20) via the connection means of the second connection module (2) and can control the electric motor (30) via the contactor (40).

## Revendications

1. Dispositif de connexion d'un appareil (10) sur site à un bus (80) sur site, comprenant un premier et un deuxième module (1, 2) de liaison, le premier module (1) de liaison comprenant un premier et un deuxième moyen (3, 4) de liaison, le premier moyen (3) de liaison servant à la liaison mécanique du premier module (1) de liaison à l'appareil (10) sur site, le deuxième moyen (4) de liaison servant à l'immobilisation mécanique de deux lignes (6, 7) du bus sur site avec le premier module (1) de liaison et à la mise en contact électrique respectivement d'un écran (9) de ligne des deux lignes (6, 7) de bus sur site avec un conducteur (5) de connexion d'écran, le deuxième module (2) de liaison pouvant, séparément du premier module (1) de liaison, être relié mécaniquement et électriquement à l'appareil (10) sur site, le deuxième module (2) de liaison comprenant un moyen (210, 220, 230) de connexion par lequel des câbles (61, 62, 71, 72) des deux lignes (6, 7) de bus sur site peuvent être reliés mécaniquement et électriquement au deuxième module (2) de liaison, le deuxième module (3) de liaison étant constitué de manière à ce que, dans l'état relié mécaniquement du deuxième module (2) de liaison à l'appareil (10) sur site, les câbles (61, 62, 71, 72) soient reliés, d'une manière conductrice de l'électricité, à l'appareil (10) sur site, **caractérisé en ce que** le deuxième module (2) de liaison est constitué pour une liaison des lignes (6, 7) de bus sur site pour une communication dans un état séparé d'un module (11) de base de l'appareil (10) sur site.

2. Dispositif suivant la revendication 1, dans lequel le dispositif comprend l'appareil (10) sur site.

3. Dispositif suivant la revendication 2, dans lequel l'appareil (10) sur site comprend un deuxième moyen de réception pour la liaison mécanique au deuxième module (2) de liaison, la liaison mécanique entre le deuxième moyen de réception et le deuxième module (2) de liaison étant une liaison à complémentarité de forme.

4. Dispositif suivant la revendication 2 ou 3, dans lequel l'appareil (10) sur site comprend, pour la liaison mécanique au premier module (1) de liaison, un premier moyen (8) de réception, la liaison mécanique entre le premier moyen (8) de réception et le premier moyen (3) de liaison du premier module (1) de liaison étant une liaison à complémentarité de forme.

5. Dispositif suivant les revendications 3 et 4, dans lequel le premier et le deuxième moyen (8) de réception se trouvent sur la même face latérale de l'appareil (10) sur site.

6. Dispositif suivant l'une des revendications précédentes, dans lequel le moyen de connexion comprend au moins une borne cage clamp ou une borne (210, 220, 230) à vis.

7. Dispositif suivant la revendication 6, dans lequel le moyen de connexion a une première et une deuxième borne cage clamp ou une première et une deuxième borne (210, 220) à vis.

8. Dispositif suivant l'une des revendications précédentes, dans lequel le moyen de connexion a un point (230) de connexion pour le conducteur (5) de connexion d'écran.

9. Dispositif suivant la revendication 8, dans lequel le deuxième module (2) de liaison comprend, pour le raccordement mécanique et électrique du conducteur (5) de connexion d'écran, une troisième borne cage clamp ou une troisième borne (230) à vis.

10. Dispositif suivant les revendications 7 et 9, dans lequel le deuxième module (2) de liaison est constitué de trois modules (21, 22, 23) de connexion, constitués de manière distincte, qui peuvent, chacun séparément les uns des autres, être reliés mécaniquement à l'appareil (10) sur site, le premier module (21) de connexion comprenant la première borne cage clamp ou la première borne (210) à vis, le deuxième module (22) de connexion comprenant la deuxième borne cage clamp ou la deuxième borne (220) à vis et le troisième module (23) de connexion comprenant la troisième borne cage clamp ou la troisième borne (230) à vis.

11. Dispositif suivant l'une des revendications précédentes, dans lequel l'appareil (10) sur site est un appareil de protection et/ou de commande de moteur (30) électrique.

12. Système comprenant un dispositif suivant l'une des revendications précédentes, comprenant un système (20) à logique programmable et un contacteur (40), qui est monté intermédiairement dans la chaîne (50) d'alimentation d'un moteur (30) électrique, l'appareil (10) sur site étant relié, par l'intermédiaire du moyen de connexion du deuxième module (2) de liaison, au bus (80) sur site du système (20) à logique programmable et pouvant être commandé par le contacteur (40) du moteur (30) électrique.
